# EUROPÄISCHE PATENTANMELDUNG

(11) **EP 2 027 948 A1**
(43) Veröffentlichungstag der Anmeldung: **25.02.2009**
(21) Anmeldenummer: 08014424.9
(22) Anmeldetag: 13.08.2008
(51) Int. Cl.: B21C 23/06, B21C 23/08, B21C 23/14, H01L 21/48, H01L 23/367

(54) **Verfahren zum Herstellen eines Flachprofils, insbesondere eines Kühlkörpers für Halbleiterelemente od.dgl. Bauteile, sowie Profil dazu**

(30) Priorität: 20.08.2007 DE 102007039253; 28.09.2007 DE 102007046684
(71) Anmelder: Alcan Technology & Management AG, 8212 Neuhausen (CH)
(72) Erfinder: Graf, Werner, 78234 Engen (DE); Bock, Stephan, 78269 Volkertshausen (DE); Cennamo, Rosario, 78239 Rielasingen (DE)
(74) Vertreter: Hiebsch, Gerhard F.

(57) **Zusammenfassung**

Bei einem Verfahren zum Herstellen eines Flachprofils aus metallischem Werkstoff -- insbesondere eines Kühlkörpers - - mit in Abstand etwa parallel zueinander von einer Grundplatte aufragenden Kühlrippen etwa stabartigen Querschnittes, die mit einem Sockelstreifen in Nuten der Grundplatte einragen sowie in diesen festgelegt werden, wird ein querschnittlich mehrkantiges Hohlprofil (50) auf dem Wege des Strangpressens hergestellt, dessen Wandungen oder Wandflächen (52, 54, 56) jeweils dem Querschnitt des Flachprofils, insbesondere einer Kühlrippe, entsprechen und die mit ihren Fußbereichen (42) jeweils an den Kopfabschnitt einer benachbarten Wandung angeformt werden; nach dem Strangpressvorgang sowie vor dem Einsatz des Flachprofils bzw. dem Anschluss der Kühlrippen an die Grundplatte des Kühlkörpers werden die Verbindungsbereiche der einzelnen Wandungen (52, 54, 56) zueinander gebrochen. Das Hohlprofil (50) ist bevorzugt als Vierkantrohr quadratischen Querschnittes ausgeformt und der Querschnitt jeder der vier Wandungen (52, 54, 56) dem Querschnitt einer Kühlrippe angepasst.

## Beschreibung

Die Erfindung betrifft ein Verfahren zum Herstellen eines Flachprofils aus metallischem Werkstoff, insbesondere eines Kühlkörpers aus einer Leichtmetall-Legierung für Halbleiterbauelement od. dgl. Bauteile mit in Anstand etwa parallel zueinander von einer Grundplatte aufragenden Kühlrippen etwa stabartigen Querschnittes, die mit einem Sockelstreifen in Nuten der Grundplatte einragen sowie in diesen festgelegt werden, nach dem Oberbegriff des Patentanspruches 1. Zudem erfasst die Erfindung ein mit diesem Verfahren behandeltes Profil.

Der DE 100 53 240 A1 ist ein Kühlkörper aus metallischen Werkstoff -- insbesondere aus einer Leichtmetall-Legierung -- für Halbleiterbauelemente od. dgl. Bauteile zu entnehmen mit in Abstand etwa parallel zueinander von einer Grundplatte aufragenden Kühlrippen etwa stabartigen Querschnittes, die mit einem Sockelstreifen in die Grundplatte einragen. Die aus Metallwerkstoff bestehende Grundplatte ist an die -- ihrerseits metallischenKühlrippen im Bereich von deren Sockelstreifen angegossen, d. h. nachträgliche Einsetz- und Verformungsvorgänge entfallen. Zudem ermöglicht der Gießvorgang die Integration von Einlegeteilen aus wärmeleitendem Werkstoff zum Erhöhen der Leitfähigkeit sowie zur Steuerung der Wärmeverteilung. Als Einlegeteile können bevorzugt sog. Wärmerohre zur Steuerung der Wärmeleitung eingegossen werden. Als Formwerkzeug dient eine Gießkokille mit Formraum für die Basis- oder Grundplatte, welchem vor dem eigentlichen Gießvorgang die aus Blech oder einem Profil erzeugten parallelen Kühlrippen so zugeordnet werden, dass deren Fußkanten samt anschließenden Sockelstreifen in den für die Gießmasse bestimmten Bereich ragen und dort von letzterer erfasst werden; nach dem Erstarren der Gießmasse ist der Kühlkörper mit den metallisch innig verbundenen Bestandteilen einsatzbereit.

Die DE 35 18 310 A1 beschreibt einen Kühlkörper mit in die Oberfläche der Grundplatte eingeformten Einsatznuten rechteckigen Querschnitts zur Aufnahme des Kupplungssockels einer Kühlrippe. Die Mittelachse der Einsatznut ist deren - - und des Kupplungssockels -- Symmetrieachse. Der Kupplungssockel ist mit Längsrippen und -- von dieses begrenzten -- längsgerichteten Seitennuten versehen, in welche während des Herstellungsprozesses durch ein verformendes -- querschnittlich keilartiges -- Werkzeug Grundplatten-Matrix eingepresst wird; so entsteht ein formschlüssiger Verbund zwischen Kühlrippe und Grundplatte. In letzterer werden durch die Verformung sowohl in Längsals auch in Querrichtung Spannungen erzeugt, die zum festen Sitz der Kühlrippen wesentlich beitragen; die Rückfederung der zwischen Einsatznut und Hilfsnut verbleibenden engen Rippenabschnitte des Grundprofiles wird kompensiert. Dieser Rückfederungseffekt nimmt naturgemäß mit steigender Festigkeit des Grundwerkstoffes zu. Entsprechend hoch müssen dann die erzeugten Spannungen in der Grundplatteund damit die Stanzkraft -- sein, was wiederum zu größeren Planheitsabweichungen der Grundplatte führen kann.

Die Kühlrippen solcher Kühlkörper bestehen aus sehr dünnen Profilen, die in einigen Fällen geriffelt sind, um eine größere Oberfläche zu haben. Diese dünnen und flachen Kühlrippen sind nur sehr schwierig und teuer zu produzieren und zudem instabil. Sie verformen sich während des Strangpressens, besonders im warmen Zustand. Wegen des instabilen Querschnitts sind die Kühlrippen auch nicht besonders gut zu handhaben. Die dünnen Kühlrippen sind leicht; das geringe Gewicht wirkt sich negativ auf die Pressleistung (in kg/Std.) und dadurch auf die Kosten aus.

Um leichte Querschnitte wirtschaftlich zu fertigen, werden sie oft mehrsträngig gepresst. Eine große Herausforderung beim Strangpressen mit mehreren Durchbrüchen ist es, den Fluss im Werkzeug so zu steuern, dass alle Querschnitte gleich schnell austreten. Ist dies nicht der Fall, verformen sich die Profile schon beim Pressen. Je dünner ein Querschnitt ist, desto genauer müssen die Fließbedingungen eingestellt sein.

In Kenntnis dieses Standes der Technik hat sich der Erfinder das Ziel gesetzt, die Herstellung von Flachprofilen aus metallischem Werkstoff zu vereinfachen; insbesondere soll ein Kühlkörper geschaffen werden, der die oben beschriebenen Mängel nicht aufweist und dessen Kühlrippen leicht herstellbar gestaltet sind.

Zur Lösung dieser Aufgabe führt die Lehre des unabhängigen Anspruches; die Unteransprüche geben günstige Weiterbildungen an. Zudem fallen in den Rahmen der Erfindung alle Kombinationen aus zumindest zwei der in der Beschreibung, der Zeichnung und/oder den Ansprüchen offenbarten Merkmale. Bei angegebenen Benennungsbereichen sollen auch innerhalb der genannten Grenzen liegende Werte als Grenzwerte offenbart und beliebig einsetzbar sein.

Erfindungsgemäß wird ein querschnittlich mehrkantiges Hohlprofil auf dem Wege des Strangpressens hergestellt, dessen Wandungen oder Wandflächen jeweils dem Querschnitt des Flachprofils, insbesondere einer Kühlrippe, entsprechen und die mit ihrem Fußbereich jeweils an den Kopfabschnitt einer benachbarten Wandung angeformt werden; nach dem Strangpressvorgang sowie vor dem Einsatz der Flachprofile -- also vor dem Anschluss der Kühlrippen an die Grundplatte des Kühlkörpers -- werden die Verbindunqsbereiche der einzelnen Wandungen zueinander gebrochen, d. h. die Wandungen voneinander getrennt. Die Anzahl der Kanten am Profilquerschnitt kann i. w. beliebig gewählt werden. Dabei wird der Querschnitt jeder zwischen zwei der Kanten des Hohlprofils verlaufenden Wandungen angepasst.

Bevorzugt wird, das Hohlprofil als Vierkantrohr quadratischen Querschnittes auszuformen und den Querschnitt jeder der vier Wandungen dem Querschnitt einer Kühlrippe anzupassen.

Nach dem Ausformen des Hohlprofils oder Mehrkantrohres wird dieses erfindungsgemäß mittels einer -- in einer durch zwei diagonal zueinander angeordnete Eckbereiche gelegten Diagonalen verlaufenden -- Formkraft so verformt, dass die beiden Eckbereiche unter Änderung des Mehrkantquerschnittes zueinander geführt werden. Als besonders günstig hat es sich erwiesen, eine Wandung des bevorzugten Vierkantrohres auf eine Haltefläche aufzulegen und die Diagonale durch einen von deren Eckbereichen zu führen, wonach die in Abstand zur Haltefläche verlaufende Wandung unter Neigung der seitlichen Wandungen zur Haltefläche hin gedrückt wird. Die Wandungen werden also während des Verformens zur Haltefläche hingeführt; die Relativbewegung der Wandungen zueinander wird durch die Verbindungsstellen zwischen ihnen gesteuert. Auch liegt es im Rahmen der Erfindung, einen Eckbereich des Mehrkantrohres auf die Halteflächen aufzusetzen und diesem den diagonal gegenüber liegenden Eckbereich zuzuführen, wobei auch hierbei die Wandungen zur Haltefläche hingeführt werden.

Der rechtwinkelige Querschnitt des Vierkantrohres wird also durch die oben erwähnte Formkraft in ein Vierkantrohr rautenförmigen Querschnittes umgeformt sowie die Verbindungsstelle jeweils zweier benachbarter Wandungen durch jene Formkraft belastet. Durch dieses erfindungsgemäße Vorgehen werden an der Verbindungsstelle jeweils zweier benachbarter Wandungen diese voneinander abgebrochen und so die einzelnen Flachprofile bzw. Kühlrippen hergestellt.

Insgesamt ergibt sich ein einfaches Verfahren zum günstigen Herstellen der Flachprofile, insbesondere der Kühlrippen und damit des gesamten Kühlkörpers.

Im Rahmen der Erfindung liegt auch ein mit diesem Verfahren behandeltes Profil. Ein auf dem Wege des Strangpressens hergestelltes querschnittlich mehrkantiges Hohlprofil weist Wandungen auf, die als Flachprofile gestaltet sind, insbesondere jeweils dem Querschnitt einer Kühlrippe entsprechen, und die mit ihren Fußbereichen jeweils nahe dem Kopfabschnitt einer benachbarten Wandung an diese angeformt sind; die Verbindungsbereiche zwischen den einzelnen Wandungen sind als Sollbruchstellen ausgebildet. Bevorzugt wird -- wie gesagt -- ein als Vierkantrohr mit vier Wandungen, dessen Wandungen sind zueinander etwa rechtwinkelig angeordnet. Vorteilhafter Weise sind zwei benachbarte Wandungen des Hohlprofils durch einen angeformten Formstreifen verbunden, der eine Ober- oder Außenfläche der einen Wandung mit der Stirnfläche der anschließenden Wandung verbindet, die etwa rechtwinkelig zur erstgenannten Wandung verläuft. Dabei soll die Stirnfläche der einen Wandung in Abstand zur Sohlenfläche der anderen Wandung an diese angeformt sein, bevorzugt durch einen schmalen Formstreifen, der an die Stirnfläche der einen Wandung sowie an die Oberfläche der anderen Wandung angeformt ist.

Nach einem weiteren Merkmal der Erfindung ist der Abstand der Verbindungsstelle der einen Wandung mit der anderen Wandung größer als die Länge des Fußbereiches der letzteren. Dieser Fußbereich der einen Wandung soll im Übrigen die Oberfläche der angeschlossenen Wandung überragen. In den Fußbereich sind erfindungsgemäß beidseits Längskerben eingeformt, bevorzugt vier Längskerben. Dabei liegen die Längskerben der einen Seite des Fußbereiches querschnittlich den Längskerben der anderen Seite gegenüber. In Anlehnung an die Form der Kühlrippen sollen die Wandungen querschnittlich durch Formwellen einen gewellten Querschnitt aufweisen; die Länge des Querschnittes einer Formwelle entspricht etwa der Breite der Wandung.

Weitere Vorteile, Merkmale und Einzelheiten der Erfindung ergeben sich aus der nachfolgenden Beschreibung eines bevorzugten Ausführungsbeispieles sowie anhand der Zeichnung; diese zeigt in
- Fig. 1:: eine Schrägsicht auf einen Kühlkörper mit von einer Grundplatte aufragenden parallelen Kühlrippen nach dem Stand der Technik;
- Fig. 2:: eine Draufsicht auf eine Vorrichtung zum Herstellen des Kühlkörpers der Fig. 1;
- Fig. 3 bis Fig. 5:: jeweils eine Schrägsicht unter die Grundplatte von drei verschiedenen Ausführungsformen des Kühlkörpers der Fig. 1;
- Fig. 6:: die Seitenansicht eines erfindungsgemäßen Kühlkörpers mit von der Grundplatte aufragenden Kühlrippen;
- Fig. 7:: die Frontansicht eines Rohlings zum Herstellen der Kühlrippen;
- Fig. 8:: einen vergrößerten Ausschnitt aus Fig. 7 gemäß deren Feld VIII;
- Fig. 9:: eine Skizze zur Herstellung der Kühlrippen aus dem Rohling der Fig. 7 in drei Verfahrensschritten;
- Fig. 10:: einen vergrößerten Querschnitt aus Fig. 9 nach deren Feld X.

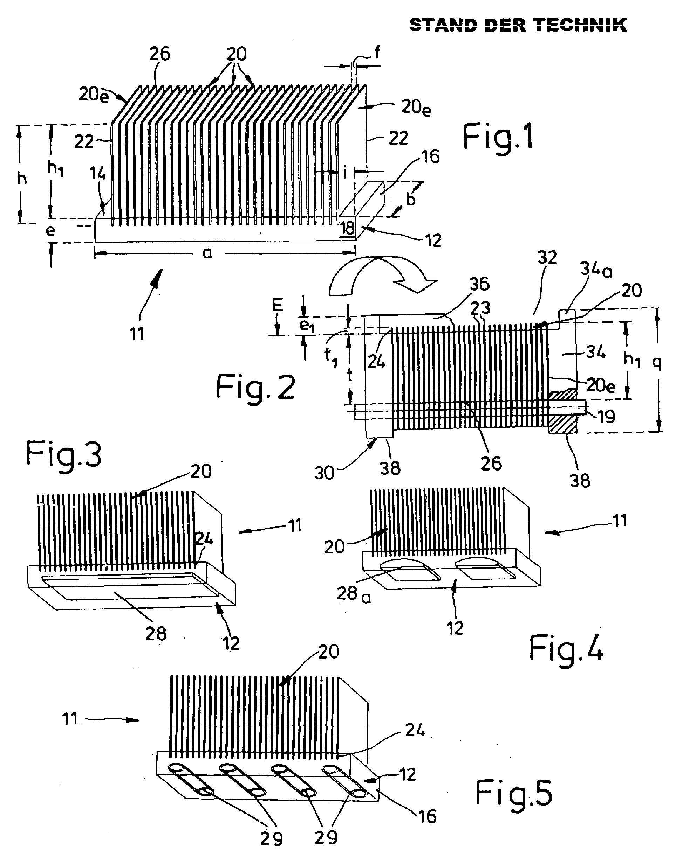

Ein längsschnittlich etwa kammartiger Kühlkörper 11 aus einer Aluminiumlegierung -- beispielsweise einer AlMgSi-Legierung -- für in der Zeichnung aus Gründen der Übersichtlichkeit nicht weiter dargestellte Halbleiterbauelemente weist eine Grundplatte 12 der Länge a, der Breite b sowie der Höhe e auf mit von deren Oberfläche 12 in freien Abständen f geringer Weite aufragenden plattenartigen dünnen Kühlrippen 20 der freien Höhe h₁. Der Abstand zwischen einer die Oberfläche 14 der Grundplatte 12 bestimmenden Ebene E und der in gezeigter Gießstellung oberen Kontur einer in Fig. 2 erkennbaren -- parallel zur Grundplatte 12 verlaufenden -- Welle 19 ist mit t bezeichnet.

Die beiden endwärtigen Kühlrippen 20ₑ verlaufen zu der jeweils benachbarten Stirnfläche 16 der Grundplatte 12 in einem horizontalen Abstand i, dessen Länge nahezu der Plattenhöhe e entspricht. Die Seitenkanten 22 der Kühlrippen 20 fluchten mit den Seitenflächen 18 der Grundplatte 12. Die massive Grundplatte 12 verteilt die Wärme und die Kühlrippen 20, 20ₑ geben diese Wärme an die Umgebung ab.

Zum Herstellen des Kühlkörpers 11 werden die aus Blech oder Profilen gefertigten Kühlrippen 20, 20ₑ der Gesamthöhe h so in eine in Fig. 2 dargestellte Kokille 30 aus Stahl eingelegt, dass jeweils ein -- von der Fußkante 23 der Kühlrippe 20, 20ₑ ausgehender -- kurzer Sockelstreifen 24 der Höhe t₁ in einen Formraum 32 der Kokille 30 ragt, dessen Boden von jene Ebene E bestimmt wird und dessen Höhe e₁ einem Mehrfachen der Höhe t₁ jenes Sockelstreifens 24 entspricht. Der Formraum 32 ist im oberen Bereich der Fig. 2 innerhalb ihn bestimmender Stirn- und Seitenwände 34, 36 der Kokille 30 zu erkennen. Die Höhe q -- zumindest -- der Stirnwände 34 ist so bemessen, dass diese in der in Fig. 2 skizzierten Gießstellung die Firstkanten 26 der Kühlrippen 20, 20ₑ mit ihren Wandstirnkanten 38 überragen. Durch das Ausgießen des Formraumes 32 entsteht die Grundplatte 12, in welche die Kühlrippen 20, 20ₑ mit ihren Fußabschnitten eingegossen -- und nach dem Erstarren festgelegt -- sind.

Je nach Anordnung der elektronischen Bauteile können vor dem Gießvorgang in den Formraum 32 plattenartige -- flach oder gewölbt ausgebildete -- Teile 28 bzw. 28ₐ aus besonders gut wärmeleitendem Material eingelegt werden, welche die Leitfähigkeit erhöhen bzw. die Wärmeverteilung steuern; diese Einlegeteile 28, 28ₐ werden gem. Fig. 3, 4 in die Grundplatte 12 eingegossen.

Statt der plattenartigen Einlegeteile 28, 28ₐ können auch sog. Wärmerohre 29 (heat-pipes) zur Steuerung der Wärmeleitung eingelegt werden, die im Beispiel der Fig. 5 in der Grundplatte 12 parallel zueinander und zu den Stirnflächen 16 verlaufen. Die Wärmerohre 29 erstrecken sich -- wie auch jene plattenartigen Einlegeteile 28, 28ₐ -- zwischen den zueinander parallelen Seitenflächen 18 der Grundplatte 12.

Die Kühlrippen 20, 20ₑ sind bei einigen Anwendungen -- zum Erzielen einer größeren Oberfläche -- geriffelt. Diese sehr dünnen und flachen Kühlrippen 20, 20ₑ sind sehr schwierig und teuer zu produzieren; sie sind verhältnismäßig instabil, weshalb sie sich während des Strangpressens verformen, dies besonders im warmen Zustand. Wegen des instabilen Querschnitts sind die Profile auch nicht besonders gut zu handhaben.

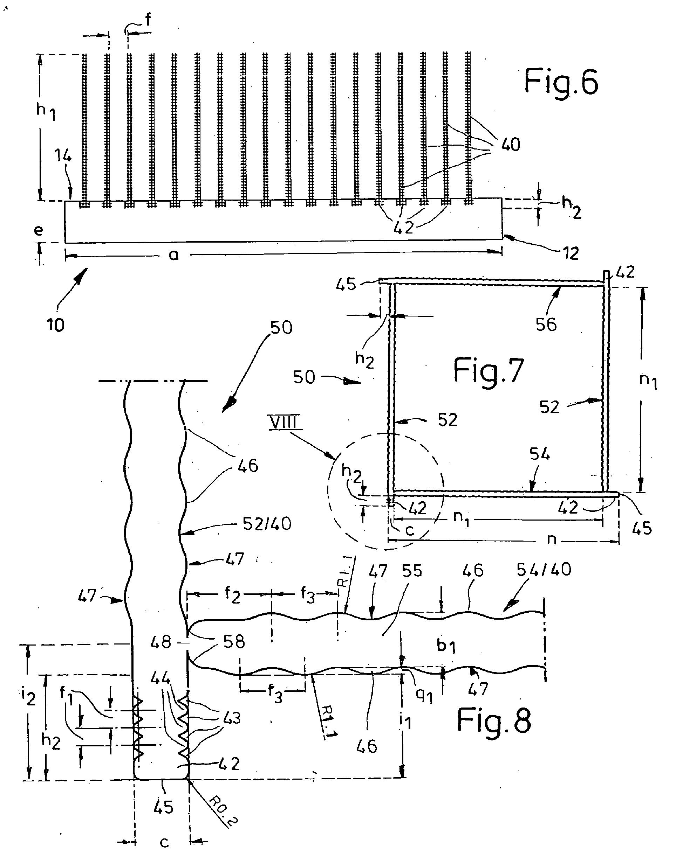

Beim Kühlkörper 10 der Fig. 6 ragen von dessen Grundplatte 12 in freien Abständen f voneinander achtzehn plattenartige Kühlrippen 40 der freien Höhe h₁ parallel auf, die jeweils mit einem Fußbereich 42 der Höhe h₂ von etwa 3 mm in Nuten dieser Grundplatte 12 eingesetzt sind, die von der letzteren Oberfläche 14 ausgehen.

Die Kühlrippen 40 werden durch Strangpressen eines in Fig. 7 verdeutlichten querschnittlich quadratischen Vierkantrohres 50 hergestellt, wobei dessen Seitenlänge n von etwa 65,55 mm zum einen die Dicke c von 1,55 mm jenes Fußbereiches 42 einer Kühlrippe 40 enthält sowie zum anderen die hier als Kraglänge vorhandene Höhe h₂ eines anderen Fußbereiches 42. Der Innenabstand n₁ zweier gegenüberliegender Wandungen als Seitenwände 52, aus denen nach der unten beschriebenen Zerteilung des Vierkantrohres 50 jeweils eine Kühlrippe 40 entsteht, misst hier etwa 59,5 mm.

Einen vergrößerten Ausschnitt des unteren linken Eckbereiches des Vierkantrohres 50 verdeutlicht Fig. 8, die den unteren Endbereich der linken Seitenwand 52 und den an diese rechtwinkelig angeformten Kopfabschnitt 55 einer anderen Wandung als Bodenwand 54 erkennen lässt, der in Fig. 7 eine Firstwand 56 des Vierkantrohres (50) gegenüber liegt. Jener Kopfabschnitt 55 der Breite b₁ von 1,37 mm verläuft in einem Abstand i₁ von 3 mm zur Sohlenflächen 45 der Seitenwand 52 bzw. der aus dieser entstehenden Kühlrippe 40. Oberhalb jener Sohlenfläche 44 sind in den Fußbereich 42 beidseits vier Längskerben 43 eingeformt, von denen in Fig. 8 die einander gegenüberliegenden Querschnitte beider Seiten sichtbar sind. Die zwischen diesen liegenden Zwischenrippen 44 verlaufen in mittigem Abstand f₁ von 0,5 mm zueinander.

Der an diesen Fußbereich 42 anschließende Teil der Seitenwand 52 bzw. der Kühlrippe 40 weist ebenso querschnittliche Formwellen 46 auf wie der quer zum Fußbereich 42 stehende Kopfabschnitt 55 der Bodenwand 54, dessen Stirnfläche 58 mittels eines schmalen Formstreifens 48 an die Oberfläche 47 der Seitenwand 52 bzw. der Kühlrippe 40 angeschlossen ist. Der Abstand des Formstreifens 48 von der Sohlenfläche 45 ist mit i₂ bezeichnet. Die Formwellen 46 beginnen hier in einem Abstand f₂ von etwa 2,4 mm vom Formstreifen 48 und verlaufen zueinander in einem axialen Abstand f₃ von etwa 1,85 mm bei einer Wellentiefe q₁ von hier 0,2 mm.

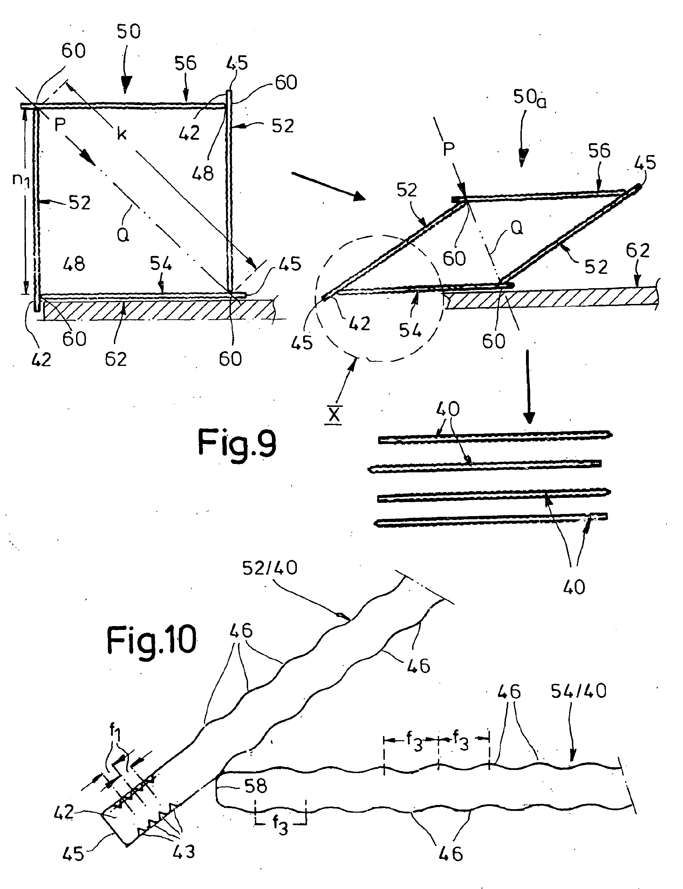

Gemäß Fig. 9 wird das -- mit der Bodenwand 54 einer Haltefläche 62 aufliegende -- Vierkantrohr 50 durch eine Druckkraft P in diagonaler Richtung Q ihres Querschnittes zusammengedrückt und dabei die diagonale Querschnittslänge k zwischen zwei einander diagonal gegenüberliegenden Eck- oder Kantenbereichen 60 vermindert bzw. der Querschnitt verflacht, wie die zweite Skizze der Fig. 9 mit dem flachen rautenartigen Querschnitt 50ₐ deutlich werden lässt. Dabei lösen sich die Stirnflächen 58 der Wandungen 52, 54, 56 von ihrem jeweiligen Anformpartner, und es entstehen die Kühlrippen 40.

Es werden also nicht mehr vier einzelne Profile 40 gepresst, sondern deren Querschnitte zueinander so angeordnet, dass sie gemeinsam ein Vierkantrohr 50 bilden. Durch dessen anschließende Verformung brechen die Profile an den Verbindungsstellen, also den Formstreifen 48, zu jenen Kühlrippen 40 auseinander und können dann getrennt weiterbehandelt werden. Dies veranschaulicht insbesondere die Skizze der Fig. 10

## Patentansprüche

1. Verfahren zum Herstellen eines Flachprofils aus metallischem Werkstoff, insbesondere eines Kühlkörpers aus einer Leichtmetall-Legierung für Halbleiterbauelemente od. dgl. Bauteil, mit in Abstand (f) etwa parallel zueinander von einer Grundplatte (12) aufragenden Kühlrippen (40) etwa stabartigen Querschnittes, die mit einem Sockelstreifen (42) in Nuten der Grundplatte einragen sowie in diesen festgelegt werden,
**dadurch gekennzeichnet,**
**dass** ein querschnittlich mehrkantiges Hohlprofil (50) auf dem Wege des Strangpressens hergestellt wird, dessen Wandungen oder Wandflächen (52, 54, 56) jeweils dem Querschnitt des Flachprofils, insbesondere einer Kühlrippe (40) entsprechen und die mit ihren Fußbereichen (42) jeweils an den Kopfabschnitt (55) einer benachbarten Wandung angeformt werden, wobei nach dem Strangpressvorgang sowie vor dem Einsatz der Flachprofile die Verbindungsbereiche der einzelnen Wandungen zueinander gebrochen werden.

2. Verfahren nach Anspruch 1, **dadurch gekennzeichnet, dass** der Querschnitt jeder zwischen zwei der Kanten des Hohlprofils (50) verlaufenden Wandung (52, 54, 56) dem Querschnitt einer Kühlrippe (40) angepasst wird.

3. Verfahren nach Anspruch 1 oder 2, **dadurch gekennzeichnet, dass** das Hohlprofil (50) als Vierkantrohr quadratischen Querschnittes ausgeformt und der Querschnitt jeder der vier Wandungen (52, 54, 56) dem Querschnitt einer Kühlrippe angepasst wird.

4. Verfahren nach einem der Ansprüche 1 bis 3, **dadurch gekennzeichnet, dass** nach dem Ausformen des Hohlprofils oder Mehrkantrohres (50) dieses mittels einer in einer durch zwei diagonal zueinander angeordnete Eckbereiche (60) gelegten Diagonalen (Q) verlaufenden Formkraft (P) so verformt wird, dass die beiden Eckbereiche unter Änderung des Mehrkantquerschnittes zueinander geführt werden.

5. Verfahren nach einem der Ansprüche 1 bis 4, **dadurch gekennzeichnet, dass** das Hohlprofil (50) mit einer Wandung (54) einer Haltefläche (62) aufgelegt wird und die anderen Wandungen (52, 56) zu dieser hingeführt werden, wobei die Relativbewegung der Wandungen zueinander durch die Verbindungsstellen zwischen ihnen gesteuert wird.

6. Verfahren nach Anspruch 3 und 5, **dadurch gekennzeichnet, dass** eine Wandung (54) des Vierkantrohres (50) der Haltefläche (62) aufgelegt und die Diagonale (D) durch einen von deren Eckbereichen (60) geführt wird, wonach die in Abstand zur Haltefläche verlaufende Wandung (56) unter Neigung der seitlichen Wandungen (52) zur Haltefläche hin gedrückt wird.

7. Verfahren nach einem der Ansprüche 1 bis 4, **dadurch gekennzeichnet, dass** das Hohlprofil (50) mit einem Eckbereich (60) einer Haltefläche (62) aufgelegt und ein diagonal angeordneter anderer Eckbereich zu dieser hingeführt wird.

8. Verfahren nach Anspruch oder 7, **dadurch gekennzeichnet, dass** der rechtwinkelige Querschnitt des Vierkantrohres (50) durch die Formkraft (P) in ein Vierkantrohr (50a) rautenförmigen Querschnittes überführt wird (Fig. 9).

9. Verfahren nach einem der Ansprüche 4 bis 8, **dadurch gekennzeichnet, dass** die Verbindungsstelle jeweils zweier benachbarter Wandungen (52, 54, 56) durch die Formkraft (P) belastet wird, wobei an der Verbindungsstelle jeweils zweier benachbarter Wandungen diese bevorzugt voneinander abgebrochen werden.

10. Profil aus metallischem Werkstoff, insbesondere eines Kühlkörpers aus einer Leichtmetall-Legierung für Halbleiterbauelemente od. dgl. Bauteil, behandelt mit dem Verfahren nach wenigstens einem der vorausgehenden Ansprüche, **dadurch gekennzeichnet, dass** ein auf dem Wege des Strangpressens hergestelltes querschnittlich mehrkantiges Hohlprofil (50) Wandungen (52, 54, 56) aufweist, die als Flachprofile gestaltet sind.

11. Profil nach Anspruch 10, **dadurch gekennzeichnet, dass** die Wandungen (52, 54, 56) jeweils dem Querschnitt einer Kühlrippe (40) entsprechen und die mit ihren Fußbereichen jeweils nahe dem Kopfabschnitt einer benachbarten Wandung angeformt sind, wobei die Verbindungsbereiche zwischen den einzelnen Wandungen als Sollbruchstellen ausgebildet sind.

12. Profil nach Anspruch 10 oder 11, **dadurch gekennzeichnet, dass** das Hohlprofil (50) als Vierkantrohr mit vier Wandungen (52) ausgebildet ist, und diese zueinander etwa rechtwinkelig angeordnet sind.

13. Profil nach einem der Ansprüche 10 bis 12, **dadurch gekennzeichnet, dass** zwei benachbarte Wandungen (52, 54, 56) durch einen angeformten Formstreifen (48) verbunden sind, der eine Ober- oder Außenfläche (47) der einen Wandung (52) mit der Stirnfläche (58) der anschließenden Wandung (54) verbindet, wobei bevorzugt ein schmaler Formstreifen vorgesehen ist, der an die Stirnfläche der einen Wandung (54) sowie an die Oberfläche der anderen Wandung (52) angeformt ist.

14. Profil nach einem der Ansprüche 10 bis 13, **dadurch gekennzeichnet, dass** die Stirnfläche (58) der einen Wandung (54) in Abstand (i₂) zur Sohlenfläche (45) der anderen Wandung (52) an diese angeformt ist (Fig. 8).

15. Profil nach Anspruch 13 oder 14, **dadurch gekennzeichnet, dass** der Abstand (i₂) der Verbindungsstelle (48) der einen Wandung (54) mit der anderen Wandung (52) größer ist als die Länge (h₂) des Fußbereiches (42)der letzteren, wobei der Fußbereich der einen Wandung bevorzugt die Oberfläche (48) der angeschlossenen Wandung (54) überragt.

16. Profil nach Anspruch 16 oder 17, **dadurch gekennzeichnet, dass** in den Fußbereich (42) beidseits Längskerben (43) eingeformt sind, bevorzugt vier Längskerben (Fig. 8), wobei die Längskerben bevorzugt der einen Seite des Fußbereiches querschnittlich den Längskerben der anderen Seite gegenüber liegen.

17. Profil nach einem der Ansprüche 10 bis 16, **dadurch gekennzeichnet, dass** die Wandungen (52, 54, 56) querschnittlich durch Formwellen (46) einen gewellten Querschnitt aufweisen, wobei die Länge (f₃) des Querschnittes einer Formwelle bevorzugt etwa der Breite (b₁) der Wandung entspricht.
